# EUROPÄISCHE PATENTSCHRIFT

(11) **EP 0 761 840 B1**
(45) Veröffentlichungstag und Bekanntmachung des Hinweises auf die Patenterteilung: **26.07.2000**
(21) Anmeldenummer: 96107866.4
(22) Anmeldetag: 17.05.1996
(51) Int. Cl.: C23C 14/50, B65G 47/90

(54) **Vorrichtung zum Greifen und Halten eines flachen Substrats**
Apparatus for gripping and holding a flat substrate
Dispositif de maintien et de préhension d'un échantillon plat

(30) Priorität: 16.08.1995 DE 19529945
(43) Veröffentlichungstag der Anmeldung: 12.03.1997
(73) Patentinhaber: Balzers und Leybold Deutschland Holding Aktiengesellschaft, 63450 Hanau (DE)
(72) Erfinder: Reising, Michael, 63776 Mömbris (DE); Kempf, Stefan, 63755 Alzenau (DE); König, Michael, 60529 Frankfurt (DE)

(56) Entgegenhaltungen:
- DE-U- 9 307 263
- US-A- 4 599 037

## Beschreibung

Die Erfindung betrifft eine Vorrichtung zum Greifen und Halten eines flachen, vorzugsweise kreisscheibenförmigen Substrats mit einer zentralen Öffnung, beispielsweise einer Compact Disc, bestehend aus mehreren fingerförmigen, in einem Gehäuse kippbar gelagerten Greifern, wobei die Greifer in Öffnungen oder Durchbrüchen im Kopfteil des Gehäuses gehalten sind, die Kippbewegungen der Greifer um Achsen quer zur Längsachse des Gehäuses gestatten.

In der Vakuum-Prozeßtechnik - insbesondere in der Dünnschicht-Technik - ist das Beschichten von kreissscheibenförmigen Substraten, beispielsweise von Glas- oder Aluminiumscheiben für magnetische oder magneto-optische Datenträger bekannt. Diese scheibenförmigen Substrate werden als Speichermedien für digitale Information vielfältig verwendet. In einem Sputterprozeß werden beispielsweise geprägte Kunststoffscheiben mit einer Aluminiumschicht überzogen. Die hierzu eingesetzten Sputter-Beschichtungsanlagen besitzen in aller Regel eine automatisierte Handling-Einrichtung für die Beförderung der Substrate vor, in und hinter einer Vakuum-Kammer.

Von einem Puffer aus transportiert beispielsweise ein Schwenkarm eines Handling-Systems die Substrate in die Vakuum-Kammer. In der Kammer werden dann die Substrate auf einen Drehteller aufgelegt und mit diesem durch die einzelnen Stationen der Vakuum-Kammer hindurchbewegt. Zum Be- und Entladen der Drehteller mit den Substraten sind im Stand der Technik zahlreiche Vorrichtungen zum Greifen und Halten bekannt.

Bisher wurden in den Vakuum-Kammern meist solche Greifer verwendet, die mittels einer Vakuum-Schiebedurchführung von außerhalb der Kammer betätigt werden.

Diese bekannten Vorrichtungen haben den Nachteil, daß sie meist zu viele bewegte Teile enthalten, daß durch die Gleitbewegungen in den Schiebedurchführungen unerwünschte Partikel erzeugt werden, die später in den Beschichtungsraum gelangen und das Beschichtungsergebnis nachteilig beeinflussen. Weiterhin läßt sich bei solchen Schiebedurchführungen in aller Regel nach einer bestimmten Betriebsdauer ein Dichtungsverschleiß feststellen, der immer eine Leckage der Vakuum-Kammer und somit eine zeit- und kostenintensive Reparatur zur Folge hat.

Man hat deshalb bereits eine Vorrichtung vorgeschlagen (G 93 07 263.5) zum Greifen und Halten eines flachen, vorzugsweise scheibenförmigen Substrats, im wesentlichen bestehend aus mehreren fingerförmigen Greifern und einer Membran aus elastischem Material, die eine in einem druckfesten Gehäuse angeordnete Öffnung verschließt, wobei auf der Vorder- und Rückseite der Membran unterschiedliche Drücke einstellbar sind und die Membran so angeordnet ist, daß sie bei anliegender Druckdifferenz eine Auslenkung aus ihrer Ruhelage ausführt und bei Druckgleichheit durch eine Druckfeder wieder in ihre Ruhelage zurückstellbar ist und wobei die Greifer mit ihrem jeweils einen Ende mechanisch mit der Membran so verbunden sind, daß sie mit ihrem anderen, freien Ende eine Schwenkbewegung proportional zur Auslenkung der Membran zum Greifen und Halten, beziehungsweise Freigeben des Substrats ausführen.

Aufgabe der vorliegenden Erfindung ist es nun, die Nachteile der bekannten Vorrichtung abzustellen und eine Vorrichtung anzugeben, die es erlaubt, Substrate inner- und außerhalb von Vakuum-Kammern besonders rasch und zuverlässig zu Greifen und zu Halten und die darüber hinaus besonders preiswert herstellbar ist und elektrisch ansteuerbar ist.

Diese Aufgabe wird erfindungsgemäß dadurch gelöst, daß die Greifer in Öffnungen oder Durchbrüchen im Kopfteil des Gehäuses gehalten und geführt sind, die Kippbewegungen der Greifer um Achsen quer zur Längsachse des Gehäuses gestatten, wobei die Kippachsen aller Greifer sich in einer Ebene erstrecken und zusammen ein die Längsachse umschließendes Vieleck bilden, wobei an den dem Substrat abgekehrten Enden der Greifer jeweils Magnete fest angeordnet sind, die mit einem im Gehäuse oberhalb der Magnete versehenen Elektromagneten zusammenwirken, dessen Magnetfeldachse mit der Längsachse des Gehäuses zusammenfällt und der die mit Magneten verbundenen Greiferenden je nach Polung des Elektromagneten zwischen zwei Anschlägen hin und her bewegt.

Weitere Einzelheiten und Merkmale der Erfindung sind in den Unteransprüchen näher gekennzeichnet und beschrieben.

Die Erfindung läßt die verschiedensten Ausführungsmöglichkeiten zu; eine davon ist in der anhängenden Zeichnung schematisch dargestellt, die den Längsschnitt durch eine Vorrichtung mit drei kippbar bzw. schwenkbar gelagerten Greifern nach der Erfindung zeigt.

Die Vorrichtung besteht im wesentlichen aus einer Metallhülse 14, die an ihrem unteren Ende drei sich radial nach innen zu erstreckende nasenförmige Anschläge 16,... aufweist, einem mit der Metallhülse 14 fest verbundenen Kopfteil 6 mit einer mit dem Kopfteil 6 verschraubten Deckplatte 8, wobei Kopfteil 6 und Deckplatte 8 jeweils mit drei Bohrungen 21,... versehen sind, durch die jeweils Greifer 4,5,... hindurchgeführt sind, deren obere Enden jeweils mit Magneten 11,12,... verbunden sind und sich bis in den Bereich der Nasen 16,... und deren untere Enden sich bis in die Ebene des Substrats 3 erstrecken und aus einem Elektromagneten 13, der einerseits auf den Nasen 16,... der Metallhülse 14 aufliegt und andererseits mittels einer Sperrings 15 arretiert ist.

Die Deckplatte 8 ist mit drei Langlöchern 9,... versehen, deren Hauptachsen jeweils im Winkel von 120° zueinander verlaufen. Die Breite der Langlöcher 9,... ist dabei so gewählt, daß die Greifer 4,5,... zwar Kippbewegungen um einen Winkel α in Richtung auf die Längsachse L, jedoch keine Bewegung quer zur jeweiligen Hauptachse ausführen können.

Die Greifer 4,5,... weisen jeweils etwa auf der Hälfte ihrer Länge eine Nut 23,... auf, in die jeweils ein O-Ring 7,... aus einem elastischen Werkstoff eingelegt ist, der seinerseits wiederum in einer entsprechenden Nut im Kopfteil 6 bzw. in der Deckplatte 8 gehalten ist und der eine Kippbewegung der Greifer 4,5,... um sich in der Ebene e erstreckende Kippachsen ermöglicht, und zwar unter geringer Verformung des jeweiligen O-Ringes 7,...

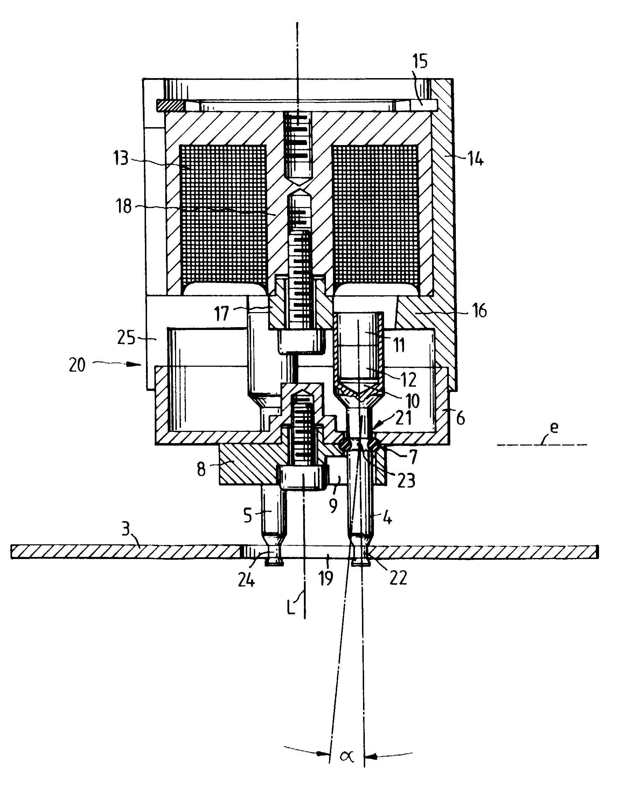

Jeder Greifer 4,5,... ist an seinem dem Substrat 3 zugewandten Ende mit einer Kerbe, einem Einschnitt oder Nut 22,24,... versehen, mit der der Greifer 4,5,... jeweils die Innenkante der zentralen Öffnung 19 greift, wobei die Zeichnung die Halteposition der Greifer 4,5,... darstellt. Werden die drei Greifer radial nach innen gekippt, d.h. ihre unteren Enden in Richtung auf die Achse L zu bewegt, dann treten die Nuten 22,24,... aus dem Randbereich der zentralen Öffnung 19 und geben das Substrat 3 frei.

Der Elektromagnet 13, der in der Hülse gehalten ist, wirkt mit den Dauermagneten 11,12,... in den Bohrungen 10,... der Greifer 4,5,... in der Weise zusammen, daß er - je nach Stromfluß - die oberen Enden der Greifer 4,5,...radial nach außen bis an die Anschläge oder Nasen 16,... zieht oder aber in entgegengesetzter Richtung an die Buchse 17, die mit dem Innenpol 18 des Elektromagneten 13 verschraubt ist.

Die Hülse 14 ist im unteren Randbereich mit Ausnehmungen 25,... versehen mit dem Vorteil, die Feldlinien des Elektromagneten 13 so zu konzentrieren, daß die Greifer 4,5,.. bzw. ihre Magneten 11,12,... möglichst rasch hin- bzw. herbewegbar sind. Der Innenpol 18 des Elektromagneten 13 ist durch die Stahlhülse 17 verlängert. Nach der Montage der Vorrichtung befinden sich die Nordpole der Dauermagnete 11,12 zwischen den beiden Hülsen 14 und 17. Durch Anlegen einer elektrischen Gleichspannung werden die beiden Hülsen 14,17 polarisiert (z.B. außen Nord, innen Süd). Durch Umkehr der Stromrichtung wird die Polarisierung umgeschaltet und damit auch die Bewegungsrichtung der Greiferenden. Der Nordpol des Dauermagneten wird vom anliegenden Pol abgestoßen und vom gegenüberliegenden Pol angezogen.

Wie die Zeichnung zeigt, sind die Dauermagnete 11,12,... in eine Bohrung des Greifers 4,5,... eingesetzt und in dieser Bohrung mit dem Greifer 4,5,... verklebt. Die die Magnete 11,12,... umschließende Wand des Greifers 4,5,... bewirkt, daß die Permanentmagnetkraft der Dauermagnete zum Polschuh 16 bzw. 17 aus Stahl größer ist als die Abstoßkraft zwischen den Dauermagneten 11,12 und dem Elektromagnet 13. Die beschriebene Vorrichtung ermöglicht eine Impuls-Ansteuerung, da zum Umschalten das elektromagnetische Feld benötigt wird, wobei aber in den End-Lagen (an den Anschlägen 17 bzw. 16,...) die Dauermagnete 11,12 die Greifer 4,5,... an der Hülse 17 bzw. 14 festhalten.

### Bezugszeichenliste

- 3: Substrat, Compact Disc
- 4: Greifer
- 5: Greifer
- 6: Kopfteil
- 7: O-Ring
- 8: Deckplatte
- 9: Schlitz, Langloch
- 10: Bohrung
- 11: Dauermagnet
- 12: Dauermagnet
- 13: Elektromagnet
- 14: Stahlhülse, Metallhülse
- 15: Federung, Sprengring
- 16: Anschlag, Nase
- 17: Stahlhülse
- 18: Innenpol, Kern
- 19: zentrale Öffnung
- 20: Gehäuse
- 21: Bohrung
- 22: Nut
- 23: Nut
- 24: Nut
- 25: Ausnehmung

## Patentansprüche

1. Vorrichtung zum Greifen und Halten eines flachen, vorzugsweise kreisscheibenförmigen Substrats (3) mit einer zentralen Öffnung (19), beispielsweise einer Compact Disc, bestehend aus mehreren fingerförmigen, in einem Gehäuse kippbar gelagerten Greifern (4,4,...), wobei die Greifer (4,5,...) in Öffnungen oder Durchbrüchen (21,...) im Kopfteil (6) des Gehäuses (20) gehalten und geführt sind, die Kippbewegungen der Greifer (4,5,...) um Achsen quer zur Längsachse (L) des Gehäuses (20) gestatten, wobei die Kippachsen aller Greifer (4,5,...) sich in einer Ebene (e) erstrecken und zusammen ein die Längsachse (L) umschließendes Vieleck bilden, **dadurch gekennzeichnet**, daß an den dem Substrat (3) abgekehrten Enden der Greifer (4,5,...) jeweils Magnete (11,12) fest angeordnet sind, die mit einem im Gehäuse (20) oberhalb der Magnete (11,12,...) vorgesehenen Elektromagneten (13) zusammenwirken, dessen Magnetfeldachse mit der Längsachse (L) des Gehäuses (20) zusammenfällt und der die mit Magneten (11,12) versehenen Greiferenden je nach Polung des Elektromagneten (13) zwischen zwei Anschlägen (16 bzw. 17) hin- und herbewegt.

2. Vorrichtung nach Anspruch 1, dadurch gekennzeichnet, daß der Elektromagnet (13) von einer Metallhülse (14) umschlossen ist, deren den Greifern (4,5,...) zugewandtes unteres Ende sich radial nach innen zu erstreckende Nasen (16,...) aufweist, an denen jeweils das obere, dem Elektromagneten (13) zugewandte Ende eines Greifers (4,5,...) anschlägt und damit dessen Kippbewegung begrenzt.

3. Vorrichtung nach den Ansprüchen 1 und 2, dadurch gekennzeichnet, daß die mit dem Kopfteil (6) des Gehäuses (20) verbundene Deckplatte (8) sich radial erstreckende Langlöcher (9,...) aufweist, in denen die Schäfte der Greifer (4,5,...) geführt sind, wobei die Langlöcher (9,...) so bemessen sind, daß sie dem jeweils zugeordneten Greifer (4,5,...) eine radial nach innen auf die Längsachse (L) zu gerichtete Kippbewegung, jedoch keine Bewegung quer zu dieser Bewegungsebene gestatten.

4. Vorrichtung nach einem oder mehreren der vorhergehenden Ansprüche, dadurch gekennzeichnet, daß das dem Elektromagneten (13) zugewandte Ende jedes Greifers (4,5,...) als Hülse für die Aufnahme von Magneten (11,12) ausgebildet ist, wobei die Länge des Greifers (4,5,...) jeweils so bemessen ist, daß die Kippbewegung des Greifers (4,5,...) einerseits von einem Anschlag (16) am Gehäuse (20) und andererseits von einem Anschlag an einer Hülse (17) begrenzt ist, die mit dem Kern bzw. Innenpol (18) des Elektromagneten (13) verbunden, beispielsweise verschraubt, ist.

## Claims

1. A device for gripping and holding a flat, preferably circular disc-shaped substrate (3) having a central aperture (19), for example a compact disc, comprising a plurality of finger-shaped grippers (4,5,...) tiltably mounted in a housing, the grippers (4,5,...) being held and guided in apertures or openings (21,...) in the head (6) of the housing (20), which allow for tilting movements of the grippers (4, 5,...) about axes transverse to the longitudinal axis (L) of the housing (20), the tilting axes of all grippers (4, 5,...) extending in a plane (e) and together forming an equilateral polygon enclosing the longitudinal axis (L), characterised in that magnets (11, 12) are fixedly arranged in each case on the ends of the grippers (4, 5,...) remote from the substrate (3), which magnets cooperate with an electromagnet (13), which is provided in the housing (20) above the magnets (11, 12,...) and whose magnetic field axis coincides with the longitudinal axis (L) of the housing (20) and moves the gripper ends provided with magnets (11, 12) back and forth between two abutments (16 or 17) as a function of the polarity of the electromagnet (13).

2. A device according to claim 1, characterised in that the electromagnet (13) is enclosed by a metal sleeve (14), whose lower end facing the grippers (4, 5,...) comprises radially inwardly extending noses (16,...), against which the upper end of a gripper (4, 5,...) facing the electromagnet (13) strikes in each case and thereby limits the tilting movement of said gripper (4, 5, ...).

3. A device according to claims 1 and 2, characterised in that the cover plate (8) connected to the head (6) of the housing (20) comprises radially extending slots (9,...), in which the shafts of the grippers (4, 5,...) are guided, the slots (9,...) being dimensioned in such a manner that they allow the respective associated gripper (4, 5, ...) a radially inward tilting movement towards the longitudinal axis (L), but prevent movement transverse to this plane of movement.

4. A device according to one or more of the preceding claims, characterised in that the end of each gripper (4, 5,...) facing the electromagnet (13) is constructed as a sleeve for receiving magnets (11, 12), the length of the gripper (4, 5,...) being dimensioned in each case in such a manner that the tilting movement of the gripper (4, 5,...) is limited on the one hand by an abutment (16) on the housing (20) and on the other hand by an abutment on a sleeve (17), which is connected, for example screwed, to the core or inner pole (18) of the electromagnet (13).

## Revendications

1. Dispositif de saisie et de maintien d'un substrat plat (3) de préférence en forme de disque circulaire présentant une ouverture centrale (19), comme par exemple un disque compact, constitué par plusieurs éléments de saisie (4, 5,...) en forme de doigts et montés en pivotement dans un boîtier, dans lequel les éléments de saisie (4, 5, ...) sont maintenus et guidés dans des ouvertures ou des traversées (21, ...) dans la partie de tête (6) du boîtier (20), lesquelles permettent des mouvements de pivotement des éléments de saisie (4, 5, ...) autour d'axes perpendiculaires à l'axe longitudinal (L) du boîtier (20), dans lequel les axes de pivotement de tous les éléments de saisie (4, 5, ...) s'étendent dans un plan (e) et forment conjointement un polygone entourant l'axe longitudinal (L), caractérisé en ce que des aimants respectifs (11, 12) sont disposés solidairement aux extrémités, détournées du substrat (3), des éléments de saisie (4, 5, ...), lesdits aimants étant en coopération avec un électroaimant (13) prévu dans le boîtier (20) au-dessus des aimants (11, 12, ...), dont l'axe du champ magnétique coïncide avec l'axe longitudinal (L) du boîtier (20) et qui déplace les extrémités, pourvues des aimants (11, 12), des éléments de saisie en va-et-vient entre deux butées (16 ou 17), en fonction de la polarisation de l'électroaimant (13).

2. Dispositif selon la revendication 1, caractérisé en ce que l'électroaimant (13) est entouré par une douille métallique (14) dont l'extrémité inférieure orientée vers les éléments de saisie (4, 5, ...) comprend des becs (16,...) qui s'étendent radialement vers l'intérieur et contre lesquels vient en butée l'extrémité respectivement supérieure, orientée vers l'électroaimant (13), d'un élément de saisie (4, 5, ...) et limite ainsi son mouvement de pivotement.

3. Dispositif selon les revendications 1 et 2, caractérisé en ce que la plaque de couverture (8) reliée à la partie de tête (6) du boîtier (20) comprend des trous oblongs (9, ...) qui s'étendent radialement et dans lesquels sont guidées les tiges des éléments de saisie (4, 5,...), les trous oblongs (9, ...) étant choisis de dimensions telles qu'ils permettent à l'élément de saisie respectivement associé (4, 5, ...) un mouvement de pivotement radialement vers l'intérieur en direction de l'axe longitudinal (L), mais non pas un mouvement transversalement à ce plan de mouvement.

4. Dispositif selon l'une ou plusieurs des revendications précédentes, caractérisé en ce que l'extrémité, orientée vers l'électroaimant (13), de chaque élément de saisie (4, 5, ...) est réalisée sous forme de douille pour recevoir les aimants (11, 12), la longueur de l'élément de saisie (4, 5, ...) étant choisie de dimension telle que le mouvement de pivotement de l'élément de saisie (4, 5, ...) est limité d'une part par une butée (16) sur le boîtier (20) et d'autre part par une butée sur une douille (17) qui est reliée, par exemple vissée, au noyau ou pôle intérieur (18) de l'électroaimant (13).
